# EUROPÄISCHE PATENTSCHRIFT

(11) **EP 0 360 744 B1**
(45) Veröffentlichungstag und Bekanntmachung des Hinweises auf die Patenterteilung: **13.10.1993**
(21) Anmeldenummer: 89810678.6
(22) Anmeldetag: 12.09.1989
(51) Int. Cl.: H05K 3/34, G03F 7/00, G03F 7/11

(54) **Verfahren zur Herstellung elektrisch leitfähiger Muster**
Process for making electrically conductive patterns
Procédé de fabrication de motifs électriquement conducteurs

(30) Priorität: 21.09.1988 GB 8822145
(43) Veröffentlichungstag der Anmeldung: 28.03.1990
(73) Patentinhaber: CIBA-GEIGY AG, 4002 Basel (CH)
(72) Erfinder: Banks, Christopher Paul, Dr., Saffron Walden Essex CB11 4DU (GB); Irving, Edward, Dr., Burwell Cambridge CB5 0AN (GB)
(74) Vertreter: Sharman, Thomas

(56) Entgegenhaltungen:
- EP-A- 0 204 415
- DE-C- 3 214 807
- US-A- 3 440 047
- US-A- 4 546 067
- US-A- 4 548 895
- US-A- 4 692 503
- US-A- 4 746 399

## Beschreibung

Die vorliegende Erfindung betrifft ein Verfahren zur Herstellung eines Musters eines elektrisch leitfähigen Materials, insbesondere eines metallischen Musters, wie beispielsweise von gedruckten Schaltungen.

Bei der Herstellung gedruckter Schaltungen bildet man üblicherweise auf einer elektrisch leitfähigen Oberfläche, in der Regel auf einer Kupferoberfläche eines kupfer-kaschierten Laminats, ein vorbestimmtes Muster eines Resists aus, wobei Siebdrucktechniken oder photographische Abbildungsverfahren angewendet werden.

Auf diese Weise erhält man ein Laminat, das in einigen Flächenanteilen freiliegendes Kupfer aufweist und worin in den verbleibenden Flächenanteilen das Kupfer mit dem Resist bedeckt ist.

Je nach Art der gedruckten Schaltung kann das Laminat verschiedenen Folgeoperationen unterzogen werden.

So lässt sich beispielsweise auf die freiliegenden Kupferflächen des Laminats direkt Lötzinn aufbringen, indem man das Laminat in ein Lötbad taucht, wobei der Resist als Lötstopplack wirkt.

In einem anderen Verfahren werden die freiliegenden Kupferflächen des Laminats mit einer Zinn-Blei Legierung plattiert, anschliessend wird der Resist entfernt, das durch die Entfernung des Resists freigelegte Kupfer wird mit Hilfe eines Aetzmittels, welches die Zinn-Blei Legierung nicht entfernt, weggeätzt und schliesslich wird die Zinn-Bleilegierung mittels eines Entmetallisierbads für Zinn-Bleilegierungen (tin-lead alloy stripper) entfernt, wobei ein Kupfermuster auf dem Trägerlaminat zurückbleibt. Dieses Kupfermuster kann dann weiter verarbeitet werden, indem man darauf einen weiteren Resist, welcher als Lötstoppmaske wirkt, in Form eines vorbestimmten Musters ausbildet, und dann das Laminat in ein Lötbad eintaucht, um auf den nicht von der Lötstoppmaske bedeckten Flächenanteilen des freiliegenden Kupfers Lötzinn aufzubringen.

Beide dieser oben erwähnten Verfahren umfassen das Aufbringen von Lötzinn, wobei ein Substrat mit einem vorbestimmten Muster einer Lötstoppmaske in ein Lötbad mit hohen Temperaturen, beispielsweise von 200 bis 500°C, eingetaucht wird. An den Lötstoppresist wird daher die Anforderung gestellt, mit den Flächenanteilen des Substrats, die nicht mit Lötzinn bedeckt werden sollen, eine hitzebeständige Verbindung einzugehen. Es besteht weiterhin ein Bedarf nach Verfahren, bei denen verbesserte hitzebeständige Verbindungen zwischen Lötstoppmaskenresists und den leitfähigen Oberflächen, auf welche besagte Resists aufgebracht werden, ausgebildet werden.

Es wurde jetzt gefunden, dass man bei der Herstellung von Mustern von leitfähigem Material hitzebeständige Verbindungen zwischen Lötstoppresists und leitfähigen Substraten herstellen kann, indem man einen Lötstoppresist mit reaktiven funktionellen Gruppen einsetzt, und vor dem Aufbringen besagten Resists auf dem leitfähigen Substrat einen Film eines organischen Polymers galvanisch abscheidet, wobei besagtes Polymer funktionelle Gruppen besitzt, die mit den funktionellen Gruppen des Resists reagieren. Nach der Bildung des Resistmusters und vor oder nach dem Entfernen der Flächenanteile des galvanisch abgeschiedenen Films, die nicht vom Resist bedeckt sind, kann das Substrat erhitzt werden, um eine hitzebeständige Haftung des Resists mit den darunterliegenden Flächenanteilen des Substrats durch Vermittlung des galvanisch abgeschiedenen Films zwischen Resist und Substrat auszubilden.

In der SU-A-293,312 und in der US-A-4,746,399 wird die galvanische Abscheidung eines Polymerfilms auf freiliegenden Metallflächen einer Substratoberfläche beschrieben, die in einem vorbestimmten Muster freiliegende Metallflächenanteile aufweist und in den übrigen Flächenanteilen mit einem Resist bedeckt ist, gefolgt von Erhitzen des Polymerfilms, Entfernung des Resists, Aetzen des dadurch freigelegten Metalls und Entfernen des galvanisch abgeschiedenen Polymeren mit einem geeigneten Lösungsmittel, wobei ein Metallmuster erhalten wird.

Keine dieser Publikationen schlägt nach dem Aetzschritt die Bildung eines Resistmusters auf dem Substrat vor, wobei der Resist reaktive Gruppen aufweist, die beim Erhitzen mit reaktiven Gruppen des galvanisch abgeschiedenen Polymerfilms reagieren können.

Die vorliegende Erfindung betrifft ein Verfahren zur Herstellung eines Musters aus einem elektrisch leitfähigen Material, umfassend die Schritte
i) galvanisches Abscheiden eines Films eines organischen Polymers, das im Mittel mehr als eine reaktive funktionelle Gruppe pro Molekül aufweist, auf eine aus dem elektrisch leitfähigen Material bestehende Oberfläche,
ii) Ausbilden eines vorbestimmten Musters eines hitzehärtbaren Resists auf dem galvanisch abgeschiedenen Film, wobei vorbestimmte Flächenanteile besagten galvanisch abgeschiedenen Films von dem Muster unbedeckt bleiben und wobei besagter hitzehärtbarer Resist im Mittel mehr als eine reaktive funktionelle Gruppe pro Molekül aufweist, die bei nachfolgendem Erhitzen mit den reaktiven funktionellen Gruppen des galvanisch abgeschiedenen Films umsetzbar ist,
iii) Entfernen der von dem Muster unbedeckten Flächen des galvanisch abgeschiedenen Films durch Behandlung mit einem Lösungsmittel für diesen Film, wobei eine Oberfläche entsteht, die in vorbestimmten Flächenanteilen freiliegendes elektrisch leitfähiges Material aufweist und die in anderen vorbestimmten Flächenanteilen elektrisch leitfähiges Material aufweist, das mit dem galvanisch abgeschiedenen Film und dem Resist bedeckt ist, und
iv) Erhitzen, um eine hitzebeständige Haftung des Resists auf der aus dem elektrisch leitfähigen Material bestehenden Oberfläche durch Vermittlung der Flächenanteile des galvanisch abgeschiedenen Films, der mit dem Resist bedeckt ist, auszubilden, wobei die Schritte iii) und iv) in beliebiger Reihenfolge ausgeführt werden können.

Polymere mit funktionellen Gruppen, die bei der galvanischen Abscheidung Filme bilden, sind an sich bekannt.

Dazu zählen beispielsweise Polymere auf Basis von ethylenisch ungesättigten Materialien, wie Acrylhomo- und -copolymere und Copolymere auf Basis von Styrolen mit Maleinsäureanhydrid; Addukte von Epoxidharzen, wie beispielsweise von Diglycidylethern von zweiwertigen Alkoholen oder von Bisphenolen, mit Aminen, wie beispielsweise mit Diethanolamin, mit Polycarbonsäuren oder deren Anhydriden, wie beispielsweise mit Glutarsäure oder mit Bernsteinsäureanhydrid, oder mit Aminocarbonsäuren, wie beispielsweise Aminobenzoesäuren; oder Reaktionsprodukte von Harzen enthaltend phenolische Hydroxylgruppen mit einem Aldehyd und einem Amin oder einer Aminocarbonsäure, beispielsweise ein Reaktionsprodukt eines phenol-terminierten Adduktes eines Diglycidylethers eines Bisphenols mit Formaldehyd und Diethanolamin oder Sarkosin. Solche Polymere weisen im Mittel pro Molekül mehr als eine reaktive funktionelle Gruppe auf. In der Regel handelt es sich dabei um eine Epoxid-, Hydroxyl-, Carboxyl- oder blockierte Isocyanatgruppe.

Das galvanisch abgeschiedene Polymer ist vorzugsweise ein Acrylpolymer, das beispielsweise ein Homopolymer einer Acrylsäure sein kann.

Bevorzugte Acrylpolymere umfassen Copolymere auf Basis wenigstens eines Monoacrylmonomeren enthaltend eine Carboxylgruppe und wenigstens eines Monoacrylesters, gegebenenfalls in Kombination mit wenigstens einem weiteren Vinylmonomeren.

Geeignete carboxylgruppenhaltige Monoacrylmonomere, von denen solche Copolymeren abgeleitet sein können, umfassen Acrylsäure, Methacrylsäure und Addukte von Hydroxyalkylacrylat oder -methacrylat mit einem Polycarbonsäureanhydrid. Acrylsäure und Methacrylsäure sind besonders bevorzugte carboxylgruppenhaltige Acrylmonomere.

Geeignete Monoacrylester, von denen die Copolymeren abgeleitet sein können, umfassen Acrylsäuremethylester, Acrylsäureethylester, Acrylsäuren-n-butylester, Acrylsäure-n-hexylester, Acrylsäure-2-ethylhexylester und die entsprechenden Methacrylate.

Vorzugsweise enthält wenigstens ein Monoacrylester eine reaktive funktionelle Gruppe, wie eine Epoxidgruppe oder insbesondere eine Hydroxylgruppe oder eine blockierte Isocyanatgruppe.

Zu den geeigneten Monoacrylestern mit solchen reaktiven Gruppen zählen beispielsweise Acrylsäure-2-hydroxyethylester, Acrylsäure-2-hydroxypropylester, Acrylsäure-3-hydroxypropylester und die entsprechenden Methacrylate, Umsetzungsprodukte von Acrylsäure-2-isocyanatoethylester oder von Methacrylsäure-2-isocyanatoethylester mit einem Blockierungsmittel für Isocyanatgruppen, wie beispielsweise in der US-A-3,542,739 beschrieben, oder Umsetzungsprodukte eines Polyisocyanats, vorzugsweise eines Tolylendiisocyanats, mit einem Acrylsäure- oder Methacrylsäurehydroxyalkylester, wie beispielsweise weiter oben beschrieben, mit einem Blockierungsmittel für Isocyanatgruppen, wie beispielsweise in der US-A-4,113,958 beschrieben.

Blockierungsmittel für Isocyanatgruppen sind an sich bekannt und umfassen beispielsweise Alkohole, Phenole, Mercaptane, primäre oder sekundäre Amine, Oxime, Triazole, Pyrazole und Lactame.

Bevorzugte Blockierungsmittel sind Oxime und Lactame.

Besonders bevorzugte Monoacrylester enthaltend reaktive Gruppen sind Methacrylsäure-2-hydroxyethylester und ein Produkt, das erhältlich ist durch Umsetzung in einer ersten Stufe von Tolylen-2,4-diisocyanat (1 Mol) mit Methacrylsäure-2-hydroxyethylester (1 Mol) und dann mit ε-Caprolactam (1 Mol).

Das gegebenenfalls anwesende Vinylmonomer, das zusammen mit dem carboxylgruppenhaltigen Monoacrylmonomeren und dem Monoacrylester copolymerisiert werden kann, ist beispielsweise ein Vinylester, wie Vinylacetat, ein Vinylhalogenid, wie Vinylchlorid, oder vorzugsweise ein Styrol, wie α-Methylstyrol, p-Chlorstyrol oder insbesondere Styrol.

Weitere bevorzugte Acrylpolymere umfassen Copolymere auf Basis von wenigstens einem Monoacrylmonomeren enthaltend eine tertiäre Amingruppe mit wenigstens einem Monoacrylester enthaltend eine reaktive funktionelle Gruppe und gegebenenfalls mit wenigstens einem weiteren Vinylmonomeren.

Geeignete Monoacrylmonomere enthaltend eine tertiäre Amingruppe, von denen sich solche Copolymeren ableiten können, umfassen Acrylsäure-dialkylaminoalkylester und Methacrylsäuredialkylaminoalkylester, bevorzugt Acrylsäure-2-(dimethylamino)-ethylester, Acrylsäure-2-(diethylamino)-ethylester, Acrylsäure-2-(dimethylamino)-propylester und die entsprechenden Methacrylsäureester, wovon Methacrylsäure-2-(dimethylamino)-ethylester besonders bevorzugt ist.

Mit dem Monoacrylmonomeren enthaltend tertiäre Aminogruppen copolymerisierbare Monoacrylester enthaltend reaktive Gruppen sind beispielsweise Acrylate oder Methacrylate enthaltend eine Epoxidgruppe oder vorzugsweise eine Hydroxylgruppe oder eine blockierte Isocyanatgruppe, wie weiter oben für die Copolymerisate von Monoacrylestern enthaltend reaktive Gruppen mit carboxylgruppenhaltigen Monoacrylmonomeren beschrieben.

Das gegebenenfalls anwesende Vinylmonomer, das zusammen mit dem Monoacrylmonomeren enthaltend eine tertiäre Aminogruppe und dem Monoacrylester enthaltend eine reaktive Gruppe copolymerisiert werden kann, ist beispielsweise ein Acrylsäure- oder Methacrylsäurealkylester, wie Acrylsäuremethylester, Acrylsäureethylester, Acrylsäure-n-butylester, Acrylsäure-n-hexylester, Acrylsäure-2-ethylhexylester und die entsprechenden Methacrylsäureester, ein Vinylester, wie Vinylacetat, ein Vinylhalogenid, wie Vinylchlorid, oder ein Styrol, wie Styrol, α-Methylstyrol oder p-Chlorstyrol.

Von diesen Monomeren sind Acrylsäure- und Methacrylsäurealkylester und Styrol bevorzugt.

Besonders bevorzugte Acrylpolymere zur Anwendung im erfindungsgemässen Verfahren sind Copolymere auf Basis von a) Acrylsäure, Methacrylsäure oder Methacrylsäure-2-(dimethylamino)-ethylester mit b) einem Acrylsäure- oder Methacrylsäure-hydroxyalkylester oder mit einem Acrylat oder Methacrylat enthaltend eine blockierte Isocyanatgruppe und mit gegebenenfalls c) wenigstens einem weiteren Vinylmonomeren, das vorzugsweise ausgewählt wird aus der Gruppe bestehend aus Acrylsäurealkylestern, Methacrylsäurealkylestern, Styrol und Mischungen von zwei oder mehreren dieser Monomeren.

Zu den besonders bevorzugten Acrylaten und Methacrylaten b) bzw. zu den Alkylacrylaten und -methacrylaten c) zählen die weiter oben beschriebenen Monomeren.

Die Acrylpolymeren können durch an sich bekannte Polymerisationsverfahren hergestellt werden, wobei Initiatoren der radikalischen Polymerisation, wie Peroxide oder Azoverbindungen, verwendet werden; man erhält damit in der Regel Polymere mit einem Zahlenmittel des Molekulargewichts von 5000 oder höher, vorzugsweise von 5000 bis 50000.

In der Regel werden die Monomeren zusammen mit dem Initiator gelöst in einem organischen Lösungsmittel erhitzt, vorzugsweise in einem Lösungsmittel, das mit dem Medium, aus dem das Polymere galvanisch abgeschieden werden soll, mischbar ist. Falls gewünscht können an sich übliche Kettenüberträger, wie tert.-Dodecylmercaptan, verwendet werden.

Die galvanische Abscheidung des organischen Polymeren kann mittels an sich bekannter Verfahren durchgeführt werden. Das galvanisch abzuscheidende Polymere kann gegebenenfalls zusammen mit an sich üblichen Zusätzen, wie Pigmenten, Farbstoffen, Füllstoffen oder Weichmachern, in einem wässrigen Medium gelöst oder dispergiert werden, das gegebenenfalls eine Kleinere Menge eines organischen Lösungsmittels in Kombination mit einer Säure oder einer Base enthalten kann, um wenigstens einen Teil der salzbildenden Gruppen des Polymeren zu neutralisieren.

Das wässrige Medium für die galvanische Abscheidung enthält im allgemeinen 2 bis 60 Gew.%, vorzugsweise 5 bis 25 Gew.%, des Polymeren. Die leitfähige Oberfläche, auf der der Polymerfilm galvanisch abgeschieden werden soll, kann in das Galvanisierbad als Anode oder als Kathode geschaltet eingetaucht werden, je nachdem, ob das Polymere anodisch oder katodisch abscheidbar ist. Eine Gegenelektrode wird in das Medium eingetaucht und ein Strom wird zwischen den Elektroden fliessen gelassen, um das Polymere auf der gewünschten Elektrode abzuscheiden.

In den meisten Fällen reicht es aus, die galvanische Abscheidung einige Minuten lang, in der Regel etwa eine Minute lang, bei einer Spannung von bis zu 200 V durchzuführen.

In einigen Fällen können tiefe Spannungen bis zu 2 V angewendet werden, insbesondere dann, wenn die Grösse der mit dem Polymerfilm zu beschichtenden Elektrode im Verhältnis zur Gegenelektrode gering ist. So lässt sich beispielsweise ein kathodisch abscheidbares Polymeres auf einer kleinen Kathode in einem als Anode geschalteten Behälter bei Spannungen von 2 oder 5 V abscheiden.

Die Haftung des Polymerfilms kann verbessert werden, wenn die Abscheidung in zwei Stufen erfolgt; zunächst bei einer niedrigen Spannung und anschliessend bei einer höheren Spannung.

So lässt sich beispielsweise ein guter Ueberzug erhalten, indem man das Polymere zunächst bei 2 V zwei Minuten lang abscheidet und dann bei 5 V bis zu fünf Minuten lang abscheidet.

Der galvanisch abgeschiedene Polymerfilm wird vor der Weiterverarbeitung in der Regel getrocknet, beispielsweise durch Erhitzen auf eine Temperatur von bis zu 110°C. Falls gewünscht, kann der Film auch auf höhere Temperaturen erhitzt werden, beispielsweise bis auf 150°C, um dessen Lösungsmittelbeständigkeit vor der Ausführung von Schritt ii) zu erhöhen.

Schritt ii) des erfindungsgemässen Verfahrens, die Ausbildung eines vorbestimmten Musters eines hitzehärtbaren Resists auf dem galvanisch abgeschiedenen Polymerfilm, kann mittels bildmässiger Photohärtung eines sich auf dem galvanisch abgeschiedenen Polymerfilms befindlichen photohärtbaren Resists ausgeführt werden, wobei dieser Resist reaktive Gruppen besitzt, die sich beim Erhitzen mit den reaktiven Gruppen im galvanisch abgeschiedenen Polymerfilm umsetzen. In dieser Ausführungsform der Erfindung wird Schritt iv) üblicherweise nach Schritt iii) ausgeführt.

Der Resist enthaltend reaktive Gruppen weist vorzugsweise photohärtbare Acrylat- oder Methacrylatgruppen auf oder besitzt α,β-ethylenisch ungesättigte Ester- oder Ketonreste mit einer aromatischen oder einer ethylenisch ungesättigten Gruppe in Konjugation mit der α,β-ungesättigten Gruppe, beispielsweise Zimtsäure-, Sorbinsäure-, Chalcon-, phenylsubstituierte Propenon- oder phenylsubstituierte Pentadienongruppen.

Der Resist weist vorzugsweise Epoxid-, Carboxyl- oder Hydroxylgruppen auf, die beim Erhitzen mit den reaktiven Gruppen im galvanisch abgeschiedenen Polymerfilm reagieren. Solche Resists sind an sich bekannt und viele unterschiedliche Typen sind kommerziell erhältlich.

Materialien, die Epoxidgruppen und konjugierte α,β-ethylenisch ungesättigte Ester- oder Ketongruppen enthalten und die als Resist geeignet sind, werden beispielsweise in der US-A-4,546,067 beschrieben.

Materialien, die Epoxidgruppen und Acrylat- oder Methacrylatgruppen enthalten, sind beispielsweise in der US-A-4,548,895 beschrieben.

Photohärtbare Zusammensetzungen enthaltend Harze mit Carboxylgruppen und Acrylat- oder Methacrylatgruppen, welche sich als Resists einsetzen lassen, sind in der GB-A-1,474,715 beschrieben.

Photohärtbare Zusammensetzungen enthaltend Carboxylgruppen und konjugierte α,β-ethylenisch ungesättigte Ketongruppen werden in der US-A-4,079,183 beschrieben.

Resists, die Acrylatgruppen und Carboxylgruppen aufweisen und die in wässrigen Medien entwickelt werden können sind von der Fa. Du Pont unter der Bezeichnung RISTON® erhältlich.

Photohärtbare hydroxylgruppenhaltige Addukte von Epoxidharzen und Acryl- oder Methacrylsäure, die sich als Resists einsetzen lassen, sind an sich bekannt und von einer Reihe von Quellen kommerziell verfügbar.

Wie dem Fachmann auf dem Gebiet der Photohärtung an sich bekannt ist, werden Materialien enthaltend photohärtbare Acrylat- oder Methacrylatgruppen in der Regel zusammen mit radikalbildenden Photoinitiatoren eingesetzt. Diese Photoinitiatoren sind im allgemeinen in den kommerziell verfügbaren Acrylharzen enthalten.

Der Resist enthaltend reaktive Gruppen kann übliche Photosensibilisatoren und weitere in herkömmlichen Photoresists übliche Zusätze enthalten. Beispiele dafür sind Farbstoffe und nicht photoempfindliche filmbildende Polymere.

Das vorbestimmte Muster des hitzehärtbaren Resists, der in Schritt ii) photogehärtet wird, kann auch durch direktes Aufbingen des Resists in Form eines vorbestimmten Musters erfolgen, beispielsweise durch Verwendung einer Siebdrucktechnik.

Vorzugsweise wird das vorbestimmte Muster des hitzehärtbaren Resists aufgebracht, indem man eine Schicht eines photohärtbaren Resists über dem galvanisch abgeschiedenen Film aufbringt, den photohärtbaren Resist mit aktinischer Strahlung in einem vorbestimmten Muster bestrahlt, um besagte Schicht in den belichteten Flächenanteilen mit Strahlung zu härten und die unbelichteten Flächenanteile der Schicht entfernt.

Die Bestrahlung der photohärtbaren Resistschicht in einem vorbestimmten Muster kann durch Belichtung durch ein bildtragendes Dia erfolgen, das aus im wesentlichen undurchlässigen und aus im wesentlichen durchlässigen Flächenanteilen besteht, oder die Belichtung kann mittels eines computergesteuteren Laserstrahls erfolgen.

Ueblicherweise verwendet man elektromagnetische Strahlung mit einer Wellenlänge von 200 bis 600 nm. Geeignete Strahlungsquellen umfassen Kohlelichtbögen, Quecksilberdampflampen, Leuchtstoffröhren mit UV-emittierenden Leuchtstoffen, Argon und Xenon Glimmlampen, Wolframlampen und photographische Flutlichtlampen; davon sind insbesondere Quecksilberdampflampen und Metall-Halogenlampen besonders geeignet.

Die Belichtungsdauer hängt üblicherweise von solchen Faktoren, wie Art der Komponenten und Dicke der photohärtbaren Resistschicht, Art der Strahlungsquelle und deren Entfernung von der Lötstoppmaske, ab. Geeignete Belichtungszeiten können auf einfache Weise durch Routineexperimente ermittelt werden.

Das Entfernen der unbelichteten Flächenanteile der bestrahlten Schicht erfolgt vorzugsweise durch Behandlung mit einem Lösungsmittel. Dieses wird entsprechend der Natur des photohärtbaren Resists ausgewählt und kann Wasser oder die wässrige oder wässrig-organische Lösung einer Säure oder einer Base oder ein organisches Lösungsmittel oder eine Mischung von Lösungsmitteln sein. Geeignete saure Lösungen umfassen Lösungen von Essigsäure, Milchsäure, Glykolsäure oder von Toluol-p-sulfonsäuren; geeignete basiche Lösungen umfassen Lösungen von Natrium- oder Kaliumhydroxid oder -carbonat.

Geeignete organische Lösungsmittel umfassen Kohlenwasserstoffe, wie Toluol oder Xylol, halogenierte Kohlenwasserstoffe, wie 1,1,1-Trichlorethan oder Dichlormethan, hydroxylgruppenhaltige Lösungsmittel, wie Ethanol, 2-n-Butoxyethanol, 2-Ethoxyethanol oder Diethylenglykol-monobutylether (Butyldigol), Ester, wie Essigsäure-2-ethoxyethylester oder Propylencarbonat, Ketone, wie Cyclohexanon, Aceton oder Methylethylketon, Ether, wie Tetrahydrofuran, und Lactone, wie Butyrolacton.

Das Lösungsmittel kann so gewählt werden, dass mit dem Entfernen der unbelichteten Flächenanteile der photohärtbaren Resistschicht ebenfalls Schritt iii) des erfindungsgemässen Verfahrens bewirkt wird, dass also die unbedeckten Flächenanteile des galvanisch abgeschiedenen Polymerfilms entfernt werden.

Die Ausbildung des vorbestimmten Musters des hitzehärtbaren Resists auf dem galvanisch abgeschiedenen Polymerfilm in Schritt ii) des erfindungsgemässen Verfahrens kann auch durch direktes Aufbingen eines hitzehärtbaren, reaktive Gruppen enthaltenden Resists auf den galvanisch abgeschiedenen Polymerfilm in Form eines vorbestimmten Musters mittels Siebdruck erfolgen.

In dieser Ausführungsform wird der Resist in der Regel durch Erhitzen gehärtet, bevor die unbedeckten Flächenanteile des galvanisch abgeschiedenen Polymerfilms durch Lösungsmittelbehandlung entfernt werden; hier wird also üblicherweise der oben definierte Schritt iii) nach dem oben definierten Schritt iv) ausgeführt.

Hitzehärtbare Resists mit reaktiven Gruppen, die sich in dieser Ausführungsform der Erfindung einsetzen lassen, enthalten vorzugsweise Epoxid-, Carboxyl- oder Hydroxylgruppen, die beim Erhitzen mit den reaktiven Gruppen im galvanisch abgeschiedenen Polymerfilm reagieren. Zu solchen Harzen zählen beispielsweise hydroxyl- oder carboxylgruppenhaltige Harze mit Acrylat- oder Methacrylatgruppen, wie sie weiter oben beschrieben wurden, welche zusammen mit thermisch aktivierbaren Radikalinitiatoren eingesetzt werden, oder Phenolharze, wie Phenol-Formaldehyd-Harze und bevorzugt Epoxidharze.

Bevorzugte Epoxidharze sind Polyglycidylether von mehrwertigen Phenolen, wie beispielsweise von Bisphenolen, wie Bisphenol A, Bisphenol F und Tetrabrombisphenol A, und von Novolaken, wie beispielsweise von Phenol-Formaldehyd- und Kresol-Formaldehyd-Novolaken, oder Mischungen davon.

Besonders bevorzugte Epoxidharze sind Diglycidylether, die gegebenenfalls vorverlängert sein können, auf Basis von Bisphenol A, Polyglycidylether von Phenol-Formaldehyd-Novolakharzen und Mischungen davon.

Obgleich ein Resist enthaltend ein Epoxidharz infolge der Wechselwirkung der Epoxidgruppen mit den reaktiven Gruppen im galvanisch abgeschiedenen Polymerfilm durch Erhitzen gehärtet werden kann, enthält der Resist vorzugsweise ein hitzeaktivierbares Härtungsmittel für das Epoxidharz, beispielsweise Dicyandiamid, ein Imidazol oder ein aromatisches Polyamin, gegebenenfalls in Kombination mit einem Beschleuniger, der üblicherweise mit solchen Härtern zusammen eingesetzt wird.

Das zur Entfernung der unbedeckten Flächenanteile des galvanisch abgeschiedenen Films in Schritt iii) eingesetzte Lösungsmittel kann aus der gleichen Gruppe ausgewählt werden, wie weiter oben bei der Entfernung der unbelichteten Flächenanteile der bestrahlten photohärtbaren Resistschicht erwähnt. Ein geeignetes Lösungsmittel kann mit Hilfe von Routineexperimenten gefunden werden.

Der Hitzeschritt iv) wird üblicherweise bei Temperaturen von 100 bis 180°C durchgeführt, abhängig von der Art des galvanisch abgeschiedenen Polymeren und des hitzehärtbaren Resists. Bei Verwendung der weiter oben beschriebenen besonders bevorzugten Polymeren und Resists wird das Erhitzen vorzugsweise bei 120 bis 150°C durchgeführt. In der Regel reicht bei diesen Temperaturen das bis zu einstündige Erhitzen aus, um eine hitzebeständige Haftung des Resists auf der elektrisch leitfähigen Oberfläche durch Vermittlung der galvanisch abgeschiedenen Zwischenschicht zu ergeben, welche beispielsweise für das folgende Eintauchen in Lötbäder üblicher Temperaturen benötigt wird. Der Hitzeschritt iv) kann auch verlängert werden, um auf Wunsch eine besonders hohe hitzebeständige Haftung zu ergeben.

Das erfindungsgemässe Verfahren eignet sich besonders gut zur Herstellung von metallischen Mustern ausgehend von einem Substrat, das eine Oberfläche mit vorbestimmten Flächen an freiliegendem Metall und in den restlichen Flächenanteilen mit einem vorher aufgebrachten Resist bedecktes Metall aufweist. Die freiliegende Metalloberfläche ist die elektrisch leitfähige Oberfläche, die weiter oben in der Definition von Schritt i) des erfindungsgemässen Verfahrens erwähnt wurde. In dieser Ausführungsform der Erfindung kann zwischen den Schritten i) und ii) der vorher aufgebrachte Resist von besagten restlichen Flächenanteilen entfernt werden, wobei ein Lösungsmittel verwendet wird, das den galvanisch abgeschiedenen Polymerfilm nicht entfernt, und dann das durch diesen Schritt freigelegte Metall in besagten restlichen Flächenanteilen mit Hilfe eines Aetzmittels, welches den galvanisch abgeschiedenen Polymerfilm nicht entfernt, geätzt werden.

Der vorher aufgebrachte Resist, welcher als Beschichtung auf dem anfänglichen Substrat vorhanden ist, kann ein Epoxidharz sein, das durch ein Siebdruckverfahren aufgebracht wurde und anschliessend gehärtet wurde. Vorzugsweise handelt es sich bei dem vorher aufgebrachten Resist um einen Photoresist, der auf ausgewählte Flächenanteile aufgebracht ist, indem man den Resist einheitlich auf das Substrat aufbringt, welches in der Regel ein kupfer-kaschiertes Laminat ist, bildmässig mit einem vorbestimmten Muster aktinischer Strahlung belichtet und anschliessend die belichteten oder die unbelichteten Flächenanteile, je nachdem ob der Photoresist positiv- oder negativ-arbeitend ist, entfernt.

Positiv- oder negativ-arbeitende Photoresists zur Verwendung bei der Herstellung gedruckter Schaltungen sind an sich bekannt und jedes dieser Materialien kann verwendet werden. Diese Resists können unter wässrigen Bedingungen oder mittels organischer Lösungsmittel entfernt werden.

Vor der galvanischen Abscheidung in Schritt ii) kann eine weitere Schicht Kupfer oder eines weiteren Metalls, wie beispielsweise Nickel, auf den freiliegenden Kupferflächen abgeschieden werden.

Man kann auch eine Kombination des vorher aufgebrachten Photoresists und des galvanisch abscheidbaren Polymeren verwenden, die beide unter sauer-wässrigen Bedingungen entfernbar sind oder die beide unter basisch-wässrigen Bedingungen entfernbar sind, mit der Massgabe, dass der Photoresist unter milderen Bedingungen entfernbar ist, als dies für die Entfernung des galvanisch abgeschiedenen Polymeren nötig ist, beispielsweise durch Behandlung mit einer stärker verdünnten Lösung einer Säure oder einer Base.

Es ist ferner möglich, einen vorher aufgebrachten Resist und ein galvanisch abscheidbares Polymer zu verwenden, die durch verschiedene organische Lösungsmittel entfernt werden können.

Besonders bevorzugt wählt man den vorher aufgebrachten Resist und das galvanisch abscheidbare Polymere so aus, dass der vorher aufgebrachte Resist mit Hilfe eines wässrigen Lösungsmittels entfernt wird und der galvanisch abscheidbare Polymerfilm mit Hilfe eines organischen Lösungsmittels in Schritt iii) entfernt wird.

Das durch das Entfernen des vorher aufgebrachten Resists freigelegte Metall, in der Regel Kupfer, kann durch an sich übliche Aetzmittel entfernt werden, beispielsweise durch Fe-III-chlorid, Wasserstoffperoxid/Phosphorsäure, Ammoniumpersulfat oder Cu-II-chlorid. Nach dem Aetzen weist das Substrat eine Oberfläche auf, die in vorbestimmten Flächen Metall enthält, das mit dem galvanisch abgeschiedenen Polymerfilm bedeckt ist, und von der in vorbestimmten Flächen Metall durch den Aetzschritt entfernt wurde. Handelt es sich bei dem anfänglichen Substrat um ein kupfer-kaschiertes Kunststofflaminat, so enthält die Oberfläche nach dem Aetzschritt vorbestimmte Flächen von Kupfer, das mit dem galvanisch abgeschiedenen Polymerfilm bedeckt ist und Flächenanteile, in denen das Kupfer auf dem Laminat fehlt.

Das erfindungsgemässe Verfahren eignet sich besonders zur Herstellung von gedruckten Schaltungen, einschliesslich der gedruckten Mehrlagenschaltungen, welche metall-plattierte durchgehende Löcher oder Stege aufweisen. Der hitzehärtbare Resist, welcher in Schritt ii) in einem vorbestimmten Muster auf dem galvanisch abgeschiedenen Polymerfilm ausgebildet wird, kann als Lötstoppmaske bei der folgenden Verarbeitung der gedruckten Schaltung verwendet werden.

Die Erfindung wird durch die folgenden Beispiele erläutert. Darin sind Teile als Gewichtsteile zu verstehen, sofern keine weiteren Angaben vorliegen. Die in den Beispielen verwendeten Polymeren werden wie folgt hergestellt:

### Polymerlösung I

Zu 2-n-Butoxyethanol (50 Teile) gibt man im Verlauf von zwei Stunden unter Rühren und bei 120°C tropfenweise eine Monomermischung bestehend aus Styrol (60 Teile), Acrylsäure-2-ethylhexylester (27,5 Teile), Methacrylsäure-2-hydroxyethylester (7,5 Teile) und Methacrylsäure-dimethylaminoethylester (5 Teile) zusammen mit Azo-bis-(isobutyronitril) (1,5 Teile). Die Reaktionsmischung wird eine weitere Stunde bei 120°C gehalten und es wird eine weitere Menge von Azo-bis-(isobutyronitril) (0,5 Teile) und 2-n-Butoxyethanol (5,5 Teile) zugegeben. Diese Verfahrensweise - einstündiges Aufrechterhalten der Temperatur von 120°C gefolgt von der Zugabe einer weiteren Menge - wird noch zweimal wiederholt und die Reaktionsmischung wird dann eine weitere Stunde bei 120°C gehalten und anschliessend abgekühlt. Das Copolymere in der resultierenden Lösung besitzt ein Molekulargewicht (Zahlenmittel) von 10'279 und die Lösung weist einen Amingehalt von 0,19 Aequ./kg auf.

### Polymerlösung II

Zu 2-n-Butoxyethanol (50 Teile) gibt man im Verlauf von zwei Stunden unter Rühren und bei 100°C tropfenweise eine Monomermischung bestehend aus Methacrylsäuremethylester (20 Teile), Acrylsäure-n-butylester (22,5 Teile), Methacrylsäure-2-hydroxyethylester (5 Teile) und Methacrylsäure (5 Teile) zusammen mit tert.-Dodecylmercaptan (0,015 Teile) und Azo-bis-(isobutyronitril) (0,75 Teile). Die Reaktionsmischung wird eine weitere Stunde bei 100°C gehalten und eine weitere Menge von Azo-bis-(isobutyronitril) (0,25 Teile) wird zugegeben. Die Reaktionsmischung wird dann drei weitere Stunden bei 100°C gehalten und vor dem Abkühlen 30 Minuten unter vermindertem Druck eingeengt. Das Copolymere in der resultierenden Lösung besitzt ein Molekulargewicht (Zahlenmittel) von 10'048 und die Lösung weist einen Carboxylgehalt von 0,30 Aequ./kg auf.

### Polymerlösung III

Eine Monomermischung bestehend aus Styrol (47,5 Teile), Acrylsäure-2-ethylhexylester (25 Teile), Methacrylsäure-2-hydroxyethylester (16 Teile), Methacrylsäure-dimethylaminoethylester (7,5 Teile) und einem blockierten isocyanathaltigen Methacrylat [4 Teile; erhalten durch Umsetzung von technischem Tolylen-2,4-diisocyanat (1 Mol) zunächst mit Methacrylsäure-2-hydroxyethylester (1 Mol) und dann mit ε-Caprolactam (1 Mol)] wird zusammen mit Azo-bis-(isobutyronitril) (1,5 Teile) und 2-n-Butoxyethanol (50 Teile) drei Stunden lang auf 100°C erhitzt. Eine weitere Menge von Azo-bis-(isobutyronitril) (0,5 Teile) und 2-n-Butoxyethanol (5,5 Teile) wird zugegeben und die Reaktionsmischung wird eine weitere Stunde bei 100°C gehalten. Diese Verfahrensweise - Zugabe einer weiteren Menge gefolgt vom Aufrechterhalten der Temperatur von 100°C für eine Stunde - wird noch zweimal wiederholt und die Reaktionsmischung wird dann abgekühlt. Das Copolymere in der resultierenden Lösung besitzt ein Molekulargewicht (Zahlenmittel) von 7'097 und die Lösung weist einen Amingehalt von 0,28 Aequ./kg auf.

Bei den RISTON® Photoresists, welche in den Beispielen eingesetzt werden, handelt es sich um Acrylatphotoresists, die von Du Pont (UK) Ltd., Riston Division, Wedgwood Way, Stevenage, Hertfordshire SG1 4QN, England, erhältlich sind.

### Beispiel 1

Ein mit RISTON® 3415 (wässrig entwickelbarer negativer Photoresist) beschichtetes kupfer-kaschiertes Laminat wird bildmässig belichtet und entwickelt und man erhält so ein Muster des Photoresists, wobei Flächenanteile von freiliegendem Kupfer zurückbleiben. Dieses Laminat wird als Kathode in einem Galvanisierbad verwendet, das mit einer Anode aus rostfreiem Stahl ausgerüstet ist. Das Bad enthält eine Lösung aus Polymerlösung I(100 Teile), wässriger 20 %iger Milchsäure (6,7 Teile) und Wasser (493 Teile). Eine Minute lang wird eine Spannung von 70 V angelegt und das Laminat wird dann aus dem Bad entfernt, mit Wasser gespült und fünf Minuten lang bei 110°C getrocknet. Der galvanisch abgeschiedene Polymerfilm bedeckt die Flächenanteile, in denen das Kupfer freigelegen hat. Das getrocknete Laminat wird in ein 50°C warmes Bad aus einer 7 %igen Lösung von Ethanolamin in Wasser eingetaucht. Diese Behandlung entfernt den Photoresist und lässt den galvanisch abgeschiedenen Polymerfilm zurück. Das durch das Entfernen des Photoresists freigelegte Kupfer wird durch Eintauchen in ein 50°C warmes Aetzbad enthaltend eine Lösung von konz. Schwefelsäure (20 Teile), Ammoniumpersulfat (150 Teile) und Wasser (830 Teile) weggeätzt. Das geätzte Laminat wird mit Wasser gespült und getrocknet, wodurch ein klares Muster aus Kupfer, das mit dem galvanisch abgeschiedenen Polymerfilm bedeckt ist, auf dem Laminatträger zurückbleibt.
Mit Hilfe einer Spiralrakel wird auf der Oberfläche enthaltend dieses Kupfermuster eine Schicht eines als Lötstoppmaske geeigneten flüssigen Photoresists aufgebracht. Der Photoresist enthält ein photohärtbares Harz enthaltend Epoxidgruppen, welches durch Vorverlängerung von 1,5-Bis-(4-glycidyloxyphenyl)-penta-1,4-dien-3-on mit Bisphenol A und Tetrabrombisphenol A hergestellt wurde, und das ein Molekulargewicht von 3'000 - 3'500 und einen Epoxidgehalt von 0,8 - 1,0 Aequ./kg aufweist (10 Teile) und Dicyandiamid als Epoxidhärter (1 Teil).
Die Schicht der Lötstoppmaske wird 10 Minuten lang bei 80°C getrocknet und dann zwei Minuten lang durch eine bildtragende Vorlage mittels einer 5 kW Metallhalogenidlampe im Abstand von 75 cm belichten. Das bestrahlte Laminat wird in eine Mischung aus Propylencarbonat (50 Teile), γ-Butyrolacton (20 Teile) und Butyldigol (30 Teile) eingetaucht, um die nicht der bildmässigen Bestrahlung ausgesetzten Flächenanteile der Lötstoppmaske und auch den dadurch freigelegten galvanisch abgeschiedenen Polymerfilm zu entfernen. Das resultierende Laminat wird 30 Minuten lang bei 130°C erhitzt um durch Vermittlung des dazwischen liegenden galvanisch abgeschiedenen Polymerfilms eine hitzebeständige Verbindung zwischen der belichteten, strahlungsgehärteten Lötstoppmaske und dem darunterliegenden Kupfermuster auszubilden.

### Beispiel 2

Ein mit dem negativ arbeitenen Photoresist RISTON® 3415 beschichtetes kupfer-kaschiertes Laminat wird bildmässig belichtet und entwickelt und man erhält so ein Muster des Photoresists und Flächenanteile von freiliegendem Kupfer. Dieses Laminat wird als Anode in einem Galvanisierbad verwendet, das mit einer Kathode aus rostfreiem Stahl ausgerüstet ist. Das Bad enthält eine Lösung aus Polymerlösung II (100 Teile), wässriger 20 %iger Kalilauge (5 Teile) und Wasser (395 Teile). Eine Minute lang wird eine Spannung von 40 V angelegt und das Laminat wird dann aus dem Bad entfernt, mit Wasser gespült und fünf Minuten lang bei 110°C getrocknet. Der galvanisch abgeschiedene Polymerfilm bedeckt die Flächenanteile, in denen das Kupfer freigelegen hat. Das getrocknete Laminat wird, wie in Beispiel 1 beschrieben, in ein Bad aus einer 7 %igen Lösung von Ethanolamin eingetaucht und im folgenden wie in Beispiel 1 beschrieben weiterbehandelt. Man erhält ein Laminat, das ein Muster einer photogehärteten Lötstoppmaske aufweist, die durch Vermittlung der Zwischenschicht des galvanisch abgeschiedenen Polymerfilms hitzebeständig auf dem darunterliegenden Kupfermuster haftet.

### Beispiel 3

Ein mit dem negativ arbeitenen Photoresist RISTON® 3415 beschichtetes kupfer-kaschiertes Laminat wird bildmässig berichtet und entwickelt, so dass ein Muster des Photoresists erhalten wird und Flächenanteile von freiliegendem Kupfer zurückbleiben. Dieses Laminat wird als Kathode in einem Galvanisierbad verwendet, das mit einer Anode aus rostfreiem Stahl ausgerüstet ist. Das Bad enthält eine Lösung aus Polymerlösung III (100 Teile), wässriger 20 %iger Milchsäure (10 Teile) und Wasser (490 Teile). Eine Minute lang wird eine Spannung von 40 V angelegt und das Laminat wird dann aus dem Bad entfernt, mit Wasser gespült und fünf Minuten lang bei 110°C getrocknet. Der galvanisch abgeschiedene Polymerfilm bedeckt die Flächenanteile, in denen das Kupfer freigelegen hat. Das getrocknete Laminat wird 30 Minuten lang bei 130°C erhitzt, um die Lösungsmittelbeständigkeit zu erhöhen. Anschliessend wird es bei 50°C in ein Bad aus einer 7 %igen Lösung von Ethanolamin in Wasser eingetaucht, um den Photoresist zu entfernen, wobei der galvanisch abgeschiedene Polymerfilm zurückbleibt. Das durch das Entfernen des Photoresists freigelegte Kupfer wird, wie in Beispiel 1 beschrieben, durch Eintauchen in ein Aetzbad weggeätzt. Das geätzte Laminat wird mit Wasser gespült und getrocknet. Man erhält ein klares Muster auf dem Trägerlaminat, worin Kupfer mit dem galvanisch abgeschiedenen Polymerfilm bedeckt ist. Mit Hilfe eine Trockenfilmlaminators wird eine Schicht eines RISTON® T215R Lötstoppmaskenresists, welcher Carboxylgruppen und photohärtbare Acrylatgruppen enthält, auf die das Kupfermuster tragende Oberfläche aufgebracht. Die Lötstoppmaske wird 15 Sekunden lang durch eine bildtragende Vorlage mittels einer 5 kW Metallhalogenidlampe im Abstand von 75 cm bestrahlt. Das bestrahlte Laminat wird in eine Lösung aus Natriumcarbonat (0,5 Teile), 2-n-Butoxyethanol (4 Teile) und Wasser (95,5 Teile) eingetaucht, um die nicht der bildmässigen Bestrahlung ausgesetzten Flächenanteile der Lötstoppmaske zu entfernen. Der dadurch freigelegte galvanisch abgeschiedene Film wird durch Eintauchen des Laminats in 1,1,1-Tricholethan entfernt. Das dadurch erhaltene Laminat wird 20 Minuten lang bei 150°C erhitzt um durch Vermittlung der Zwischenschicht aus galvanisch abgeschiedenem Polymerfilm eine hitzebeständige Verbindung zwischen der belichteten, strahlungsgehärteten Lötstoppmaske und dem darunterliegenden Kupfermuster auszubilden.

### Beispiel 4

Man wiederholt das Verfahren von Beispiel 3 bis zur Stufe der Ausbildung des mit dem galvanisch abgeschiedenen Polymerfilm bedeckten klaren Kupfermusters auf dem Laminatträger. Auf die Oberfläche enthaltend das Kupfermuster wird mittels eines Trockenfilmlaminators eine Schicht von RISTON® 3415, einem Lötstopphotoresist enthaltend Carboxylgruppen und photohärtbare Acrylatgruppen, aufgebracht. Die Lötstoppmaske wird 15 Sekunden lang durch eine bildtragende Vorlage mittels einer 5 kW Metallhalogenidlampe im Abstand von 75 cm bestrahlt. Das bestrahlte Laminat wird in eine 1 %ige wässrige Lösung aus Natriumcarbonat eingetaucht, um die nicht der bildmässigen Bestrahlung ausgesetzten Flächenanteile der Lötstoppmaske zu entfernen. Der dadurch freigelegte galvanisch abgeschiedene Film wird durch Eintauchen des Laminats in 1,1,1-Trichlorethan entfernt. Das resultierende Laminat wird 20 Minuten lang bei 150°C erhitzt, um durch Vermittlung der Zwischenschicht aus galvanisch abgeschiedenem Polymerfilm eine hitzebeständige Verbindung zwischen der belichteten, strahlungsgehärteten Lötstoppmaske und dem darunterliegenden Kupfermuster auszubilden.

### Beispiel 5

Man wiederholt das Verfahren von Beispiel 1 bis zur Stufe der Ausbildung des mit dem galvanisch abgeschiedenen Polymerfilms bedeckten klaren Kupfermusters auf dem Laminatträger. Mit Hilfe von Siebdruck wird ein Muster eines hitzehärtbaren Lötstoppmaskenresists auf ausgewählte Flächenanteile des mit dem galvanisch abgeschiedenen Films bedeckten Kupfers auf dem Trägerlaminat aufgebracht. Der Lötstoppresist enthält einen Polyglycidylether auf Basis eines Phenol-Formaldehyd-Novolaks mit einem Epoxidgehalt von 5,7 Aequ./kg (10 Teile), 4,4,'-Diaminodiphenylmethan (5,7 Teile) und Cyclohexanon (5 Teile). Das Laminat wird eine Stunde lang auf 150°C erhitzt, um die Lötstoppmaske zu härten und eine hitzebeständige Verbindung zwischen der Lötstoppmaske und dem darunterliegenden Kupfer über den dazwischenliegenden galvanisch abgeschiedenen Polymerfilm auszubilden. Die Flächenanteile des galvanisch abgeschiedenen Polymerfilms, die durch den Siebdruckprozess nicht mit der Lötstoppmaske bedeckt wurden, werden anschliessend durch Eintauchen des Laminats in 1,1,1-Trichlorethan entfernt.

## Patentansprüche

1. Verfahren zur Herstellung eines Musters aus einem elektrisch leitfähigen Material, umfassend die Schritte
i) galvanisches Abscheiden eines Films eines organischen Polymers, das im Mittel mehr als eine reaktive funktionelle Gruppe pro Molekül aufweist, auf eine aus dem elektrisch leitfähigen Material bestehenden Oberfläche,
ii) Ausbilden eines vorbestimmten Musters eines hitzehärtbaren Resists auf dem galvanisch abgeschiedenen Film, wobei vorbestimmte Flächenanteile besagten galvanisch abgeschiedenen Films von dem Muster unbedeckt bleiben und wobei besagter hitzehärtbarer Resist im Mittel mehr als eine reaktive funktionelle Gruppe pro Molekül aufweist, die bei nachfolgendem Erhitzen mit den reaktiven funktionellen Gruppen des galvanisch abgeschiedenen Films umsetzbar ist,
iii) Entfernen der von dem Muster unbedeckten Flächen des galvanisch abgeschiedenen Films durch Behandlung mit einem Lösungsmittel für diesen Film, wobei eine Oberfläche entsteht, die in vorbestimmten Flächenanteilen freiliegendes elektrisch leitfähiges Material aufweist und die in anderen vorbestimmten Flächenanteilen elektrisch leitfähiges Material aufweist, das mit dem galvanisch abgeschiedenen Film und dem Resist bedeckt ist, und
iv) Erhitzen, um eine hitzebeständige Haftung des Resists auf der aus dem elektrisch leitfähigen Material bestehenden Oberfläche durch Vermittlung der Flächenanteile des galvanisch abgeschiedenen Films, der mit dem Resist bedeckt ist, auszubilden, wobei die Schritte iii) und iv) in beliebiger Reihenfolge ausgeführt werden können.

2. Verfahren gemäss Anspruch 1, dadurch gekennzeichnet, dass besagtes organisches Polymer, welches im Mittel pro Molekül mehr als eine reaktive funktionelle Gruppe aufweist, ein Polymer auf Basis eines ethylenisch ungesättigten Materials; ein Addukt von einem Epoxidharz mit einem Amin, mit einer Polycarbonsäure oder deren Anhydrid oder mit einer Aminocarbonsäure; oder ein Reaktionsprodukt von einem Harz enthaltend phenolische Hydroxylgruppen mit einem Aldehyd und einem Amin oder einer Aminocarbonsäure ist.

3. Verfahren gemäss Anspruch 2, dadurch gekennzeichnet, dass besagtes organisches Polymer ein Copolymer von wenigstens einem Monoacrylmonomeren enthaltend eine Carboxylgruppe und wenigstens einem Monoacrylester ist, gegebenenfalls in Kombination mit wenigstens einem anderen Vinylmonomeren.

4. Verfahren gemäss Anspruch 3, dadurch gekennzeichnet, dass besagter Monoacrylester eine reaktive funktionelle Gruppe enthält.

5. Verfahren gemäss Anspruch 2, dadurch gekennzeichnet, dass besagtes Polymer ein Copolymer auf Basis von wenigstens einem Monoacrylmonomeren enthaltend eine tertiäre Amingruppe und von wenigstens einem Monoacrylester enthaltend eine reaktive funktionelle Gruppe ist, gegebenenfalls in Kombination mit wenigstens einem anderen Vinylmonomeren.

6. Verfahren gemäss Anspruch 2, dadurch gekennzeichnet, dass besagtes Polymer ein Copolymer auf Basis von a) Acrylsäure, Methacrylsäure oder Methacrylsäure-2-(dimethylamino)-ethylester mit b) einem Acrylsäure- oder Methacrylsäure-hydroxyalkylester oder mit einem Acrylat oder Methacrylat enthaltend eine blockierte Isocyanatgruppe und gegebenenfalls mit c) wenigstens einem weiteren Vinylmonomeren ist.

7. Verfahren gemäss einem der Ansprüche 1 bis 6, dadurch gekennzeichnet, dass ein vorbestimmtes Muster eines hitzehärtbaren Resists mittels Photohärtung eines photohärtbaren Harzes in einem vorbestimmten Muster ausgebildet wird, wobei besagtes photohärtbares Harz reaktive Gruppen enthält, die beim Erhitzen mit den reaktiven Gruppen im galvanisch abgeschiedenen Film umsetzbar sind, und wobei Schritt iv) nach Schritt iii) ausgeführt wird.

8. Verfahren gemäss Anspruch 7, dadurch gekennzeichnet, dass der Resist photohärtbare α,β-ethylenisch ungesättigte Ester- oder Ketonreste mit einer aromatischen oder einer ethylenisch ungesättigten Gruppe in Konjugation zu der α,β-ungesättigten Gruppe, oder photohärtbare Acrylat- oder Methacrylatgruppen aufweist.

9. Verfahren gemäss Anspruch 7 oder 8, dadurch gekennzeichnet, dass das vorbestimmte Muster des hitzehärtbaren Resists aufgebracht wird, indem man eine Schicht eines photohärtbaren Resists über dem galvanisch abgeschiedenen Film aufbringt, den photohärtbaren Resist mit aktinischer Strahlung in einem vorbestimmten Muster bestrahlt, um besagte Schicht in den belichteten Flächenanteilen mit Strahlung zu härten und die unbelichteten Flächenanteile der Schicht entfernt.

10. Verfahren gemäss Anspruch 9, dadurch gekennzeichnet, dass besagte unbelichtete Flächenanteile durch Behandlung mit einem Lösungsmittel entfernt werden, wobei die Lösungsmittelbehandlung auch das Entfernen der von dem Muster unbedeckten Flächenanteile des galvanisch abgeschiedenen Films gemäß Schritt iii) bewirkt.

11. Verfahren gemäss einem der Ansprüche 1 bis 6, dadurch gekennzeichnet, dass das vorbestimmte Muster des hitzehärtbaren Resists durch direktes Aufbingen besagten Resists in Form eines vorbestimmten Musters durch Siebdruck erfolgt, und dass Schritt iii) nach Schritt iv) ausgeführt wird.

12. Verfahren gemäss einem der Ansprüche 1 bis 11, dadurch gekennzeichnet, dass die elektrisch leitfähige Oberfläche eine in vorbestimmten Flächenanteilen freiliegende Metalloberfläche auf einem Substrat ist, welches eine Oberfläche aufweist, worin in vorbestimmten Flächenanteilen freiliegendes Metall und in den verbleibenden Flächenanteilen ein mit einem vorher aufgebrachten Resist bedecktes Metall auftritt.

13. Verfahren gemäss Anspruch 12, dadurch gekennzeichnet, dass zwischen den Schritten i) und ii) der vorher aufgebrachte Resist von besagten verbleibenden Flächenanteilen entfernt wird, wobei ein Lösungsmittel verwendet wird, das den galvanisch abgeschiedenen Film nicht entfernt, und dann das durch diesen Schritt freigelegte Metall in besagten verbleibenden Flächenanteilen mit Hilfe eines Aetzmittels, welches den galvanisch abgeschiedenen Film nicht entfernt, geätzt wird.

14. Verfahren gemäss Anspruch 13, dadurch gekennzeichnet, dass der vorher aufgebrachte Resist mit Hilfe eines wässrigen Lösungsmittels entfernt wird und der galvanisch abgeschiedene Film mit Hilfe eines organischen Lösungsmittels in Schritt iii) entfernt wird.

15. Verfahren gemäss einem der Ansprüche 1 bis 14, dadurch gekennzeichnet, dass das elektrisch leitfähige Muster eine gedruckte Schaltung ist.

## Claims

1. A method of making a pattern of an electrically conductive material, which comprises the steps of
i) electrodepositing a film of an organic polymer having on average more than one reactive functional group per molecule on a surface consisting of the electrically conductive material,
ii) forming on the electrodeposited film a predetermined pattern of a heat-curable resist, predetermined areas of said electrodeposited film remaining uncovered by the pattern and said heat-curable resist having on average more than one reactive functional group per molecule which is able to be converted on subsequent heating with the reactive functional groups of the electrodeposited film,
iii) removing the areas of the electrodeposited film not covered by the pattern by treatment with a solvent for this film, to form a surface having bare electrically conductive material in predetermined areas and, in other predetermined areas, having electrically conductive material covered by the electrodeposited film and the resist, and
iv) heating to develop heat-resistant adhesion of the resist to the surface consisting of the electrically conductive material by means of the areas of the electro-deposited film covered by the resist, steps iii) and iv) being able to be carried out in any order.

2. A method according to claim 1, wherein said organic polymer, which has on average more than one reactive functional group per molecule, is a polymer based on an ethylenically unsaturated material; an adduct of an epoxide resin with an amine, with a polycarboxylic acid or anhydride thereof or with an aminocarboxylic acid; or a reaction product of a phenolic hydroxyl group-containing resin with a aldehyde and an amine or an aminocarboxylic acid.

3. A method according to claim 2, wherein said organic polymer is a copolymer of at least one monoacrylic monomer containing a carboxyl group and at least one monoacrylic ester, optionally combined with at least one other vinyl monomer.

4. A method according to claim 3, wherein said monoacrylic ester contains a reactive functional group.

5. A method according to claim 2, wherein said polymer is a copolymer based on at least one monoacrylic monomer containing a tertiary amine group and at least one monoacrylic ester containing a reactive functional group, optionally combined with at least one other vinyl monomer.

6. A method according to claim 2, wherein said polymer is a copolymer based on (a) acrylic acid, methacrylic acid or 2-dimethylaminoethyl methacrylate with (b) a hydroxyalkyl acrylate or methacrylate or a blocked isocyanate group-containing acrylate or methacrylate, and optionally with (c) at least one further vinyl monomer.

7. A method according to one of claims 1 to 6, wherein a predetermined pattern of a heat-curable resist is formed by photocuring in a predetermined pattern a photocurable resin, said photocurable resin containing reactive groups which can be reacted with the reactive groups in the electrodeposited film on heating, and step iv) is carried out after step iii).

8. A method according to claim 7, wherein the resist has photocurable α,β-ethylenically unsaturated ester or ketone radicals having an aromatic or ethylenically unsaturated group in conjugation with the α,β-unsaturated group, or has photocurable acrylate or methacrylate groups.

9. A method according to claim 7 or 8, wherein the predetermined pattern of heat-curable resist is applied by applying a layer of a photocurable resist over the electrodeposited film, irradiating the photocurable resist with actinic radiation in a predetermined pattern to radiation-cure said layer in the exposed areas, and removing the unexposed areas of the layer.

10. A method according to claim 9, wherein said unexposed areas are removed by treatment with a solvent, the solvent treatment also effecting removal of the areas of the electrodeposited film not covered by the pattern, according to step iii).

11. A method according to one of claims 1 to 6, wherein the predetermined pattern of heat-curable resist is formed by applying said resist directly in a predetermined pattern by screen printing, and step iii) is carried out after step iv).

12. A method according to one of claims 1 to 11, wherein the electrically conductive surface is a metal surface bare in predetermined areas on a substrate having a surface comprising bare metal in predetermined areas and a metal covered by a previously applied resist in the remaining areas.

13. A method according to claim 12, wherein between steps i) and ii) the previously applied resist is removed from said remaining areas using a solvent which does not remove the electrodeposited film, and the metal exposed by this step in said remaining areas is then etched using an etchant which does not remove the electrodeposited film.

14. A method according to claim 13, wherein the previously applied resist is removed using an aqueous solvent and the electrodeposited film is removed using an organic solvent in step iii).

15. A method according to one of claims 1 to 14, wherein the electrically conductive pattern is a printed circuit.

## Revendications

1. Procédé pour réaliser un motif en un matériau électro-conducteur, procédé comprenant les étapes consistant :
i) à déposer par électrolyse un film d'un polymère organique, comportant en moyenne plus d'un groupe fonctionnel réactif par molécules, sur une surface constituée du matériau électro-conducteur ;
ii) à réaliser un motif prédéfini d'une réserve pouvant durcir sous l'effet de la chaleur, sur le film déposé par électrolyse, des zones prédéfinies de la surface du film mentionné ci-dessus, déposé par électrolyse, restant non recouvertes par le motif, la réserve mentionnée ci-dessus pouvant durcir sous l'effet de la chaleur, comportant en moyenne plus d'un groupe fonctionnel réactif par molécule, et qui, après un chauffage effectué après coup, peut réagir avec les groupes réactifs fonctionnels du film déposé par électrolyse ;
iii) à éliminer les zones du film déposé par électrolyse non recouvertes du motif, par traitement avec un solvant pouvant dissoudre ce film, de façon à créer une surface qui, dans certaines zones prédéfinies, présente un matériau électro-conducteur dégagé et qui, dans d'autres zones prédéfinies, comporte un matériau électro-conducteur, lequel est recouvert du film déposé par électrolyse et de la réserve ; et
iv) à chauffer, pour réaliser un joint collé résistant à la chaleur entre la réserve et la surface constituée du matériau électro-conducteur, par l'intermédiaire des zones de la surface du film déposé par électrolyse recouvertes de la réserve, les étapes iii) et iv) pouvant être mises en oeuvre dans un ordre quelconque.

2. Procédé selon la revendication 1, caractérisé en ce que ledit polymère organique, qui en moyenne par molécule comporte plus d'un groupe fonctionnel réactif, est un polymère à base d'un composé à insaturation éthylénique ; un produit d'addition d'une résine époxydique et d'une amine, d'un acide polycarboxylique ou de son anhydride, ou d'un acide aminocarboxylique ; ou encore un produit de la réaction d'une résine contenant des groupes hydroxyle phénoliques avec un aldéhyde et une amine ou un acide aminocarboxylique.

3. Procédé selon la revendication 2, caractérisé en ce que ledit polymère organique est un copolymère d'au moins un monomère monoacrylique contenant un groupe carboxyle et d'au moins un monoester d'acide acrylique, éventuellement en combinaison avec au moins un autre monomère vinylique.

4. Procédé selon la revendication 3, caractérisé en ce que ledit monoester d'acide acrylique contient un groupe fonctionnel réactif.

5. Procédé selon la revendication 2, caractérisé en ce que ledit polymère est un copolymère à base d'au moins un monomère monoacrylique contenant un groupe amino tertiaire et d'au moins un monoester d'acide acrylique contenant un groupe fonctionnel réactif, éventuellement en combinaison avec au moins un autre monomère vinylique.

6. Procédé selon la revendication 2, caractérisé en ce que ledit polymère est un copolymère à base a) d'acide acrylique, d'acide méthacrylique ou de méthacrylate de 2-diméthylaminoéthyle, et b) d'un acrylate ou méthacrylate d'hydroxyalkyle ou d'un acrylate ou méthacrylate contenant un groupe isocyanate bloqué, et éventuellement c) d'au moins un autre monomère vinylique.

7. Procédé selon l'une des revendications 1 à 6, caractérisé en ce qu'on forme un motif prédéfini d'une réserve durcissable à la chaleur, par photo-durcissement d'une résine photo-durcissable selon un motif prédéfini, où ladite résine photo-durcissable contient des groupes réactifs qui, au chauffage, peuvent réagir avec les groupes réactifs du film déposé par électrolyse, l'étape iv) étant effectuée après l'étape iii).

8. Procédé selon la revendication 7, caractérisé en ce que la réserve contient des radicaux ester ou cétone photo-durcissables à insaturation alpha, bêta-éthylénique, comportant un groupe aromatique ou un groupe à insaturation éthylénique en conjugaison avec le groupe alpha, bêta-insaturé, ou encore des groupes acrylates ou méthacrylates photo-durcissables.

9. Procédé selon la revendication 7 ou 8, caractérisé en ce qu'on applique le motif prédéfini de la réserve durcissable à la chaleur en appliquant une couche d'une réserve photo-durcissable sur le film déposé par électrolyse, en exposant la réserve photo-durcissable à un rayonnement actinique selon un motif prédéfini, pour durcir sous l'effet du rayonnement ladite couche dans les zones superficielles exposées, et en enlevant les zones non exposées de la couche.

10. Procédé selon la revendication 9, caractérisé en ce que lesdites zones superficielles non exposées sont enlevées par traitement à l'aide d'un solvant, le traitement au solvant provoquant aussi l'enlèvement des zones, non recouvertes par le motif, du film déposé par électrolyse selon l'étape iii).

11. Procédé selon l'une des revendications 1 à 6, caractérisé en ce que le motif prédéfini de la réserve durcissable à la chaleur est réalisé par sérigraphie, par application directe de ladite réserve sous forme d'un motif prédéfini, l'étape iii) étant mise en oeuvre après l'étape iv).

12. Procédé selon l'une des revendications 1 à 11, caractérisé en ce que la surface électro-conductrice est une surface métallique d'un substrat, dégagée dans certaines zones prédéfinies, substrat comportant une surface dans laquelle, dans certaines zones prédéfinies, il existe du métal dégagé, et, dans les autres zones superficielles, il existe un métal recouvert d'une réserve déjà appliquée.

13. Procédé selon la revendication 12, caractérisé en ce que, entre les étapes i) et ii), on enlève, des zones superficielles restantes, la réserve déjà appliquée, en utilisant un solvant qui n'enlève pas le film déposé par électrolyse, puis, dans les zones superficielles restantes, on décape le métal dégagé par cette étape, à l'aide d'un décapant qui n'enlève pas le film déposé par électrolyse.

14. Procédé selon la revendication 13, caractérisé en ce que la réserve déjà appliquée est enlevée à l'aide d'un solvant en solution aqueuse, et que le film déposé par électrolyse est enlevé à l'aide d'un solvant organique dans l'étape iii).

15. Procédé selon l'une des revendications 1 à 14, caractérisé en ce que le motif électro-conducteur est un circuit imprimé.
